Europäisches Patentamt

(19) European Patent Office

Office européen des brevets

(11) **EP 0 730 278 B1**

(12) **EUROPEAN PATENT SPECIFICATION**

(45) Date of publication and mention
of the grant of the patent:
**12.12.2001 Bulletin 2001/50**

(51) Int Cl.⁷: **G11C 17/00**

(86) International application number:
**PCT/JP95/01711**

(21) Application number: **95929246.7**

(22) Date of filing: **29.08.1995**

(87) International publication number:
**WO 96/07182 (07.03.1996 Gazette 1996/11)**

(54) **SEMICONDUCTOR MEMORY DEVICE**

HALBLEITERSPEICHERANORDNUNG

DISPOSITIF DE MEMOIRE A SEMI-CONDUCTEURS

(84) Designated Contracting States:
**DE FR GB**

(30) Priority: **31.08.1994 JP 20654594**

(43) Date of publication of application:
**04.09.1996 Bulletin 1996/36**

(73) Proprietor: **Oki Electric Industry Company,
Limited
Tokyo 105 (JP)**

(72) Inventors:
• **KAI, Nobuhiro
Oki Micro Design Miyazaki Co., Ltd.
Miyazaki-shi Miyazaki-pref 880 (JP)**
• **KOKUBUN, Hitoshi
Oki Electric Industry Co., Ltd.
Minato-ku Tokyo 105 (JP)**

(74) Representative: **Betten & Resch
Postfach 10 02 51
80076 München (DE)**

(56) References cited:
EP-A- 0 241 693          JP-A- 5 268 065
JP-A- 60 111 529         JP-B- 3 018 277
US-A- 4 467 225          US-A- 4 951 259

• IEEE JOURNAL OF SOLID-STATE CIRCUITS,
vol. 20, no. 5, October 1985, NEW YORK US,
pages 971-978, XP002010052 JOLLY ET AL: "A
35-ns 64K EEPROM"
• PATENT ABSTRACTS OF JAPAN vol. 5, no. 134
(P-77) [806] , 26 August 1981 & JP-A-56 071881
(FUJITSU KK), 15 June 1981,
• PATENT ABSTRACTS OF JAPAN vol. 6, no. 188
(P-144) [1066] , 28 September 1982 & JP-A-57
098175 (MITSUBISHI DENKI KK), 18 June 1982,

## Description

Technical Field

The present invention relates to a storing circuit for use with a semiconductor storing apparatus, in particular, a non-volatile memory such as a mask ROM (Read Only Memory) with a large storage capacity.

Related Art

A conventional non-volatile memory has an X decoder that drives a word line corresponding to a memory cell. The X decoder has a P channel type field effect transistor (hereinafter referred to as PMOS) and an N channel type field effect transistor (hereinafter referred to as NMOS) that are connected between a power voltage and a node. A connected portion of the PMOS and the NMOS is connected to the word line.

However, as the storage capacity of the mask ROM increases, the gate length of the NMOS of the X decoder tends to decrease.

Thus, in the standby state, if the voltage of the word line is high (hereinafter, this state is referred to as H level) and the voltage of the node is low (hereinafter, this state is referred to as L level), a leak current may flow in the PMOS due to the short channel effect.

From US 4,951,259 a semiconductor memory disclosing the features of the preamble of claim 1 of the present application is known including a plurality of word line drivers and logic decoding circuitry coupled to the inputs of the word line drivers. In order to reduce the capacity loads of the word line driver circuits a switching arrangement is provided between the output of the logic decoding circuitry and the word line drivers, which switching arrangement can be controlled to respectively connect the output of the logic decoding circuit to the word line drivers based on control output signals of a pre-decoder. Each word line driver is formed of a pair of transistors forming therebetween a word line input node. One of the electrodes of the second transistor of said word line drivers is grounded. Therefore leakage through the gate of this second transistor may occur if the voltage level of a word line differs from that of ground level. This problem is particularly relevant in the case of narrow gates.

From JP-A-56071881 a semiconductor memory device is known having an additional transistor at the final stage gate circuit for decreasing an access delay to the memory cell information. The word line is connected with a node formed between two word line driver transistors. One electrode of one of these two transistors is grounded so that a leakage current may occur in the case the word line has a voltage level different from ground level in a standby state.

From US 4,467,225 an address selection device for a semiconductor memory is known comprising an address buffer for receiving an address selection signal to produce an output signal which is complementary to the address selection signal and a decoder circuit for decoding the address selection signal which includes a plurality of MOS transistors connected in parallel with one another and for receiving at their gates corresponding address bit signals of the address selection signal, a MOS transistor as a load resistor connected in series with said plurality of MOS transistors, and a MOS transistor connected between the load resistor MOS transistor and a power source terminal for operating a power source switch and for receiving at the gate specified bit signal of the complementary signal applied from the address buffer.

An object of the present invention is to provide a semiconductor memory device that can prevent the flowing of a leakage current in a standby state and to decrease power consumption.

This object is solved by the semiconductor memory device as defined in claim 1. Further advantageous embodiments of the invention are defined in the dependent claims.

Brief Description of Drawings

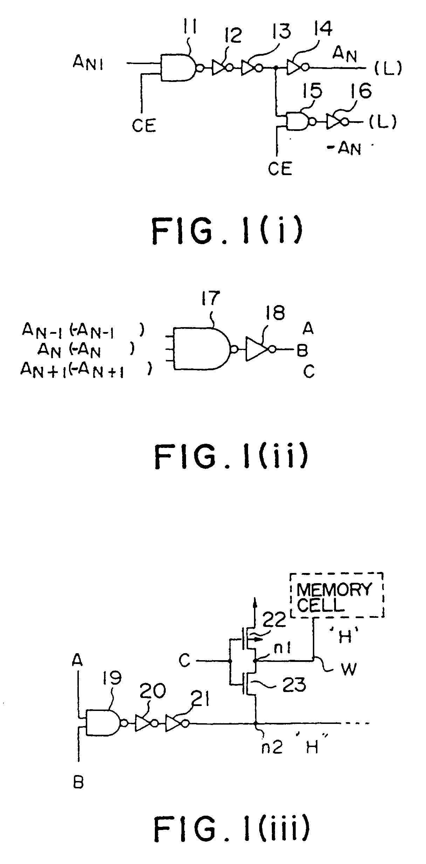

Fig. 1 (i) is a circuit diagram showing an address buffer element circuit;
Fig. 1 (ii) is a circuit diagram showing a predecoder element circuit;
Fig. 1 (iii) is a circuit diagram showing an X decoder element circuit;
Fig. 2 is a circuit diagram showing a conventional address buffer element circuit;
Fig. 3 is a circuit diagram showing a predecoder element circuit for use with a non-volatile memory according to a second embodiment of the present invention;
Fig. 4 is a circuit diagram showing a predecoder element circuit for use with a non-volatile memory according to a third embodiment of the present invention;
Fig. 5 is a circuit diagram showing an X decoder element circuit for use with a non-volatile memory according to a fourth embodiment of the present invention;

Fig. 6 is a circuit diagram showing an X decoder element circuit for use with a non-volatile memory according to a fifth embodiment of the present invention;

Fig. 7 is a circuit diagram showing an X decoder element circuit for use with a non-volatile memory according to a sixth embodiment of the present invention;

Fig. 8 is a circuit diagram showing an X decoder element circuit for use with a non-volatile memory according to a seventh embodiment of the present invention;

Fig. 9 is a circuit diagram showing an X decoder element circuit for use with a non-volatile memory according to an eighth embodiment of the present invention;

Fig. 10 is a circuit diagram showing an X decoder element circuit for use with a non-volatile memory according to a ninth embodiment of the present invention;

Fig. 11 is a circuit diagram showing connections of address buffer element circuits and predecoder element circuits; and

Fig. 12 is a circuit diagram showing connections of X decoder element circuits and the circuits shown in Fig. 11.

Best Modes for Carrying out the Invention

[First Embodiment]

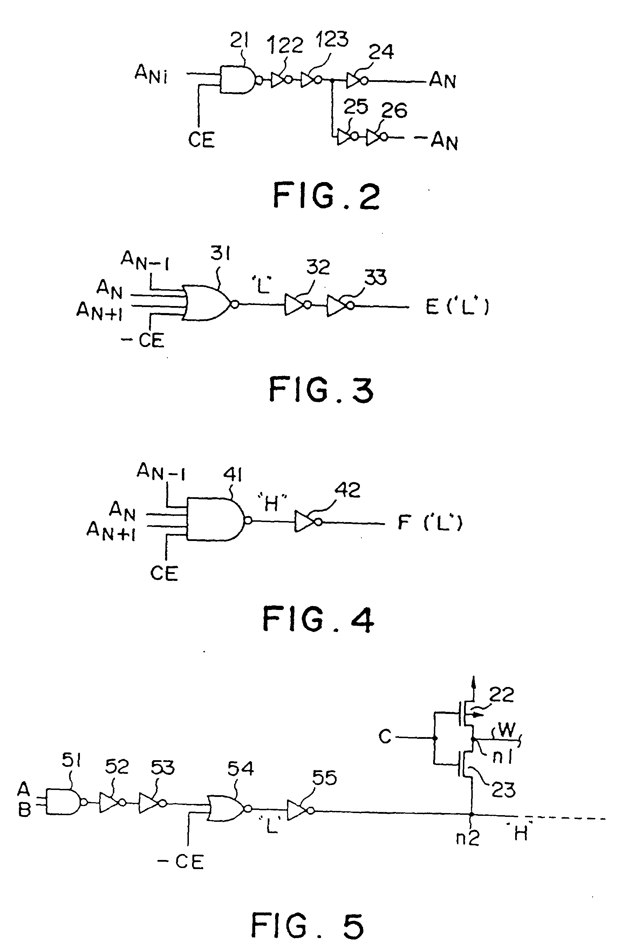

Figs. 1 (i), 1 (ii), and 1 (iii) are circuit diagrams for explaining a non-volatile memory according to a first embodiment of the present invention. Fig. 1 (i) shows an address buffer element circuit. Fig. 1 (ii) shows a predecoder element circuit. Fig. 1 (iii) shows an X decoder element circuit. Fig. 2 shows a conventional address buffer circuit.

Figs. 1 (i), 1 (ii), and 1 (iii) show elements circuits for an address buffer, a predecoder, and an X decoder. However, in a real non-volatile memory, a plurality of element circuits are used corresponding to the number of memory cells.

First of all, the structure of a conventional address buffer element circuit shown in Fig. 2 will be described. The address buffer has a two-input type NAND gate 21 that inputs an input address signal ANi in TTL (Transistor Transistor Logic) level and a chip enable signal CE. Two inverters 122 and 123 are connected in series to an output portion of the NAND gate 21. An input portion of an inverter 24 is connected to an output portion of the inverter 23. An address signal AN is output from an output portion of the inverter 24. Two inverters 25 and 26 are connected in serial to the output portion of the inverter 123. An inverted signal of the address signal AND is output from an output portion of the inverter 26. (Hereinafter, the inverted signal of the address signal AN is denoted by -AN.)

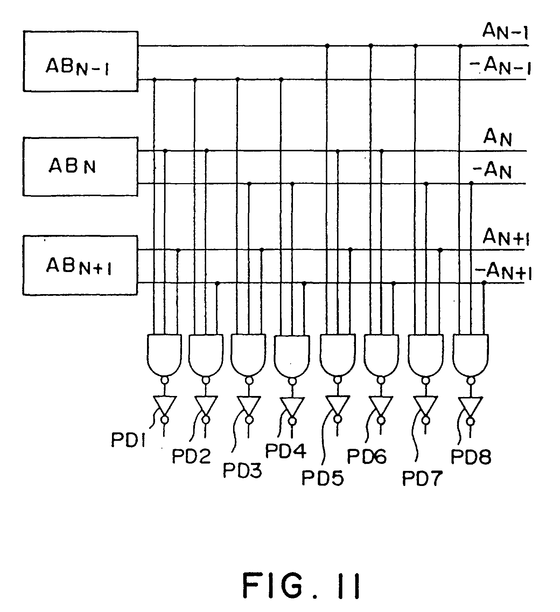

Next, the structure of the predecoder element circuit shown in Fig. 1 (ii) will be described. The predecoder element circuit has an NAND gate that inputs output signals (AN and -AN) of a plurality of address buffer element circuits. In Fig. 1 (ii), the NAND gate 17 has three input portions. Any three of six output signals (AN-1, AN, AN+1, -AN-1, -AN, and -AN+1) are input to the three input portions of the NAND gate 17. Fig. 11 shows connections of address buffer element circuits and predecoder element circuits. As shown in Fig. 11, in this case, three address buffer element circuits (ABN-1, ABN, and ABN+1) and eight predecoder element circuits (PD1, PD2, PD3, PD4, PD5, PD6, PD7, and PD8) are connected. An output signal -AN-1 of the address buffer element circuit ABN-1, an output signal AN of the address buffer element circuit ABN, and an output signal AN+1 of the address buffer element circuit ABN+1 are input to the three input portions of the predecoder PD1. Likewise, output signals -AN-1, AN, and -AN+1 are input to input portions of the predecoder PD2. Output signals -AN-1, -AN, and AN+1 are input to input portions of the PD3. Output signals -AN-1, -AN, and -AN+1 are input to input portions of the PD4. Output signals AN-1, AN, and AN+1 are input to input portions of the PD5. Output signals AN-1, AN, and -AN+1 are input to input portions of the PD6. Output signals AN-1, -AN, and AN+1 are input to input portions of the PD7. Output portions AN-1, -AN, and -AN+1 are input to input portions of the PD8. Thus, when a predecoder element circuit has three input portions, three address buffer element circuits and eight predecoder element circuits are connected as a combination circuit.

Next, the structure of the X decoder shown in Fig. 1 (iii) will be described. The X decoder has an two-input type NAND gate 19 that inputs signals A and B. Two inverters 20 and 21 are connected in series to an output portion of the two-input type NAND gate. A PMOS 22 and an NMOS 23 are connected in series to a source voltage node and an output portion (n2) of the inverter 21. A signal C is input to gates of the PMOS 22 and the NMOS 23. A connected portion (n1) of the PMOS 22 and the NMOS 23 is connected to a word line W. A plurality of memory cells are connected to the word line.

Next, the signals A, B, and C will be described. As described above, when the input portion of a predecoder element circuit has three inputs portions, three address buffer element circuits and eight predecoder element circuits are connected as one combination circuit (see Fig. 11). Thus, this combination circuit has eight output portions. The signal A is a signal that is output from any of eight output portions. The signal B is a signal that is output from any of eight output portions of the combination circuit composed of other address buffer element circuits and predecoder unit circuits. The signal C is any of eight signals that is output from other combination circuits. Thus, in this case, (8 x 8 x 8) X decoder element circuits are required.

It should be noted that the NAND gate 19 of the X decoder element circuit may have six input portions. In this case, the address signal that is input to the predecoder element circuit may be directly input to the X decoder element circuit. In this case, the predecoder element circuit can be omitted. However, when a high speed operation is required, it is preferable to use the predecoder.

Next, the operations of the address buffer element circuit shown in Fig. 2, the predecoder element circuit shown in Fig. 1 (ii), and the X decoder element circuit shown in Fig. 1 (iii) will be described. Since an object of the present invention is to prevent a leak current in standby state, the operation in the standby state will be described in particular.

The level of the chip enable signal CE is L in the standby state, whereas the level of the chip enable signal CE is H in the active state. Thus, in the standby state, regardless of the logic level of the input address ANi, the level of an output signal of the NAND gate 1 becomes H. Thus, the level of the address signal AN becomes L. The level of the signal -AN becomes H. In this case, the level of an output signal of only the three-input type NAND gate of the PD4 of the eight predecoder element circuits of the combination circuit shown in Fig. 11 becomes L. Thus, the level of an output signal of only the predecoder element circuit PD4 becomes H. The levels of output signals of the other seven predecoder element circuits (PD1, PD2, PD3, PD5, PD6, PD7, and PD8) become L. Consequently, the level of an output signal of only one of eight output portions of the combination circuit becomes H.

Thus, only one of (8 x 8 x 8) X decoder element circuits satisfies the conditions of which all the levels of the signals A, B, and C are H. In this case, since the PMOS 22 and the NMOS 23 shown in Fig. 1 (iii) are turned off and on, respectively, the word line W is connected to the node n2. In addition, the level of the output signal of the NAND gate 19 becomes L. Thus, the level of the output signal of the inverter 21 becomes L. The level of the word line W becomes L. This state is equivalent to the condition that one word line W is selected in the active state.

Seven of (8 x 8 x 8) X decoder element circuits satisfy the conditions of which the level of the signal A is H, the level of the signal B is H, and the level of the signal C is L. In this case, since the PMOS 22 and the NMOS 23 are turned on and off, respectively, the level of the word line W becomes H. The level of the NAND gate becomes L. Thus, the level of the output signal of the inverter 21 becomes L and the voltage level of the node n2 becomes L.

49 of (8 x 8 x 8) X decoder element circuits satisfy the conditions of which the level of the signal A is L, the level of the signal B is H, and the level of the signal C is L. In this case, since the PMOS 22 and the NMOS 23 are turned on and off, respectively, the voltage level of the word line W becomes H. In addition, since the level of the output signal of the NAND gate 19 becomes H, the level of the output signal of the inverter 21 becomes H and the voltage level of the node n2 becomes H.

Seven of (8 x 8 x 8) X decoder element circuits satisfy the conditions of which the level of the signal A is L, the level of the signal B is H, and the level of the signal C is H. In this case, the PMOS 22 and the NMOS 23 are turned off and on, respectively. In addition, since the level of the output signal of the NAND gate becomes H, the level of the output signal of the inverter 21 becomes H and the voltage level of the node n2 becomes H. Thus, the voltage level of the word line W becomes H.

49 of (8 x 8 x 8) X decoder element circuits satisfy the conditions of which the level of the signal A is H, the level of the signal B is L, and the level of the signal C is L. In this case, since the PMOS 22 and the NMOS 23 are turned on and off, respectively, the voltage level of the word line W becomes H. In addition, since the level of the output signal of the NAND gate 19 becomes H, the level of the output signal of the inverter 21 becomes H and the voltage level of the node n2 becomes H.

Seven of (8 x 8 x 8) X decoder element circuits satisfy the conditions of which the level of the signal A is H, the level of the signal B is L, and the level of the signal C is H. In this case, the PMOS 22 and the NOS 23 are turned off and on, respectively. Since the level of the output signal of the NAND gate 19 becomes H, the level of the output signal of the inverter 21 becomes H and the voltage level of the node n2 becomes H. Thus, the voltage level of the word line W becomes H.

49 of (8 x 8 x 8) X decoder element circuits satisfy the conditions of which the level of the signal A is L, the level of the signal B is L, and the level of the signal C is H. In this case, the PMOS 22 and the NMOS 23 are turned off and on, respectively. In addition, since the level of the output signal of the NAND gate 19 becomes H, the level of the output signal of the inverter 21 becomes H and the voltage level of the node n2 becomes H. Thus, the level of the word line W becomes H.

343 of (8 x 8 x 8) X decoder element circuits satisfy the conditions of which the level of the signal A is L, the level of the signal B is L, and the level of the signal C is L. In this case, the PMOS 22 and the NMOS 23 are turned on and off, respectively. Thus, the voltage level of the word line W becomes H. In addition, since the level of the output signal of the NAND gate 19 becomes H, the level of the output signal of the inverter 21 becomes H and the voltage level of the node n2 becomes H.

Table 1 shows the voltage levels of the signals A, B, and C, the ON/OFF states of the transistors 22 and 23, and the voltage levels of the word line W and the node n2.

[Table 1]

| A | B | C | Tr22 | Tr23 | W | n2 | NO. OF X DECODERS |
|---|---|---|------|------|---|----|--------------------|
| H | H | H | OFF | ON | L | L | 1 |
| H | H | L | ON | OFF | H | L | 7 |
| L | H | L | ON | OFF | H | H | 49 |
| L | H | H | OFF | ON | H | H | 7 |
| H | L | L | ON | OFF | H | H | 49 |
| H | L | H | OFF | ON | H | H | 7 |
| L | L | H | OFF | ON | H | H | 49 |
| L | L | L | ON | OFF | H | H | 433 |

As described above, in the case that the level of the signal A becomes H, that the level of the signal B becomes H, and that the level of the signal C becomes L, the voltage level of the word line W becomes H and the voltage level of the node n2 becomes L. Thus, in the transistor 23, due to the short channel effect, a leak current takes place. Consequently, a current may flow in the word line W.

Next, the structure of the address buffer element circuit shown in Fig. 1 (i) will be described. Referring to Fig. 1 (i), the address buffer element circuit has a two-input type NAND gate 11 that inputs an input address signal ANi and a chip enable signal CE. Two inverters 12 and 13 are connected in series to an output portion of the NAND gate 11. An input portion of the inverter 14 is connected to an output portion of the inverter 13. An address signal AN is output from an output portion of the inverter 14. In addition, the address buffer element circuit has a two-input type NAND gate 15 that inputs an output signal of the inverter 13 and a chip enable signal CE. An inverter 16 is connected to an output portion of the NAND gate 15. When the level of the CE signal is H, an inverted signal of the address signal AN (the inverted signal is denoted by -AN) is output from an output portion of the inverter 16.

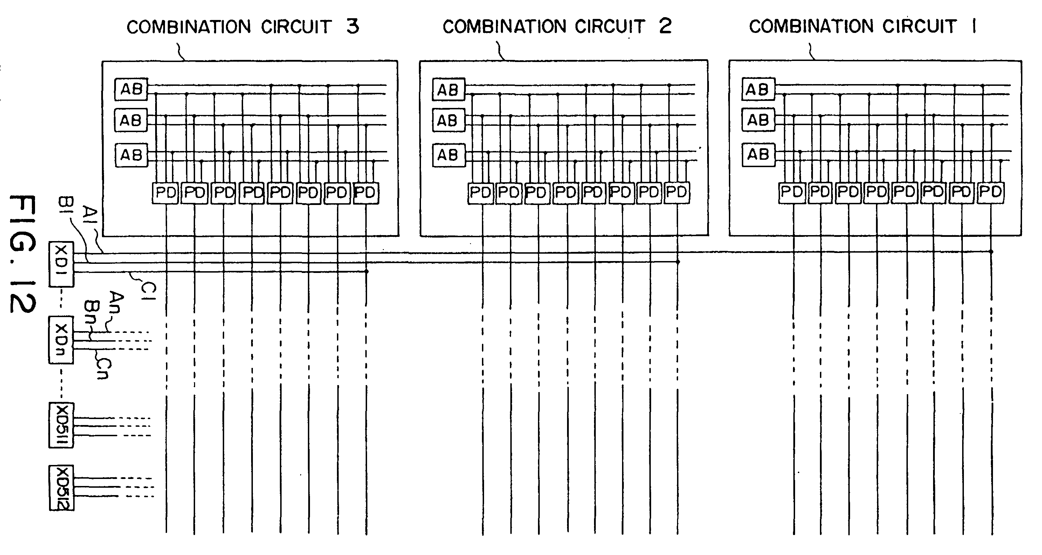

Next, with reference to Figs. 11 and 12, the operation of circuitry that has the address buffer element circuits shown in Fig. 1 (i) will be described.

Fig. 12 shows connections of three terminals (An, Bn, and Cn) of the above-described (8 x 8 x 8 = 512) X decoders (XDn, where n = 1 to 512) and three combination circuits 1, 2, and 3. In each of the these combination circuits, three address buffer element circuits AB are used. Thus, in the circuit shown in Fig. 12, nine address buffer element circuits AB are used. In this case, as a necessary condition, at least one of six address buffer element circuits AB of the combination circuits 1 and 2 shown in Fig. 12 has the structure shown in Fig. 1 (i) and the rest of the address buffer element circuits has the structure shown in Fig. 2.

Next, the case in which the exclusive address buffer element circuit in the combination circuit 1 shown in Fig. 12 has the structure shown in Fig. 1 (i) will be described.

In the standby state, the level of the chip enable signal CE is L. In the active state, the level of the chip enable signal CE is H. Thus, in the circuit shown in Fig. 1 (i), in the standby state, regardless of the logic level of the input address ANi, the level of the output signal of the NAND gate 11 is H. Thus, the level of the address signal AN becomes L. In addition, since the chip enable signal CE is input to one input of the NAND gate 15, the level of the output signal of the NAND gate 15 becomes H and the level of the signal -AN becomes L.

In this case, at least one signal in the L level is input to input terminals of the eight three-input type predecoders PD of the combination circuit 1. In other words, there is no predecoders that input signals that are all in the H level. Thus, the levels of the output signals of the eight predecoders PD become L. Consequently, a signal (A) in the L level is always input to one of input portions of the NAND gate 19 of the X decoder XD shown in Fig. 1 (ii). In other words, signals in the H level are not input to both the input portions of the NAND gate 19 at the same time. Thus, the level of the output signal of the NAND gate 19 of the X decoder becomes H and the voltage level of the node n2 becomes H.

Table 2 shows the voltage levels of the signals A, B, and C, the ON/OFF states of the transistors 22 and 23, and the voltage levels of the word line and the node n2.

[Table 2]

| A | B | C | Tr22 | Tr23 | W | n2 | NO. OF X DECODERS |
|---|---|---|------|------|---|----|--------------------|
| L | H | L | ON | ON | H | H | 56 |

[Table 2] (continued)

| A | B | C | Tr22 | Tr23 | W | n2 | NO. OF X DECODERS |
|---|---|---|------|------|---|----|----|
| L | H | H | OFF | ON | H | H | 8 |
| L | L | H | OFF | ON | H | H | 56 |
| L | L | L | ON | OFF | H | H | 392 |

Thus, according to the first embodiment of the present invention, in the address buffer element circuit shown in Fig. 1 (i), when the chip enable signal is invalid, (namely, when the level of the signal CE is L), the levels of the address signals AN and -AN become L. Thus, all the predecoders connected to the address buffer element circuit output signals in the L level. Consequently, the voltage level of the node n2 of the X decoder becomes H. In other words, the voltage level of the node n2 is fixed to the same voltage level as the word line W. Thus, even if the levels of the input signals of the gates of the PMOS 22 and the NMOS 23 that drive each word line become H or L, the levels of all the word lines are fixed to H.

Thus, according to the first embodiment, the address buffer element circuit outputs the addresses AN and -AN that are in the L level in the case that the level of the signal CE is L. Thus, in the chip standby state, the level of the output signal of the node n2 can be fixed to H. Consequently, regardless of whether the level of the signal C of the predecoder element circuit is L or H, in the chip standby state, the logic levels of all the word line W are always set to H. Thus, in the chip standby state, the levels of the nodes n2 (the drain of the NMOS 23) and the node n1 (the source of the NMOS 23) always become H, thereby preventing a leak current due to the short channel effect from taking place.

[Second Embodiment]

Fig. 3 is a circuit diagram showing a predecoder element circuit for use with a non-volatile memory according to a second embodiment of the present invention.

The second embodiment is a modification of a predecoder element circuit connected to an address buffer. The predecoder element circuit has an NOR gate 31. Two inverters 32 and 33 are connected in series to an output portion of the NOR gate 31. Output addresses AN-1, AN, and AN+1 of an address buffer element circuit and a signal -CE that is complementary to the chip enable signal CE are input to the NOR gate 31.

Next, the circuit operation of the non-volatile memory according to the second embodiment will be described. In this case, AB shown in Fig. 12 is an address buffer element circuit shown in Fig. 2. PD of the combination circuit 1 is a predecoder element circuit shown in Fig. 3. XDn is an X decoder element circuit shown in Fig. 1 (ii). In this case, as a necessary condition, a predecoder element circuit of any of the combination circuits 1 and 2 of the three combination circuits shown in Fig. 12 has the structure shown in Fig. 3.

When the logic level of the signal -CE of the circuit shown in Fig. 3 is H (namely, in the chip standby state), regardless of the logic levels of the address signals AN-1, AN, and AN+1, the level of the output signal of the NOR 31 becomes L.

Thus, the level of the signal A is always L. In other words, since a signal (A) in the L level is always input to one of input signals of a NAND gate 19 of the X decoder XD shown in Fig. 1 (iii), the level of the output signal of the NAND gate 19 of the X decoder becomes H and the voltage level of the node n2 becomes H. Consequently, even if the logic levels of the input signals of the gates of the PMOS 22 and the NMOS 22 that drive each word line become H or L, the levels of all the word lines are fixed to H.

Thus, according to the second embodiment, the predecoder element circuit outputs a signal in the L level in the case that the level of the signal CE is L. Thus, in the chip standby state, the level of the output signal of the node n2 can be fixed to H. Consequently, regardless of the level of the output signal of the address buffer element circuit, in the chip standby state, the levels of all the word lines W are always set to H. As a result, in the chip standby state, the levels of the node n2 (the drain of the NMOS 23) and the node n1 (the source of the NMOS 23) become H, thereby preventing a leak current due to the short channel effect from taking place.

[Third Embodiment]

Fig. 4 is a circuit diagram showing a predecoder element circuit for use with a non-volatile memory according to a third embodiment of the present invention.

The third embodiment is a modification of a predecoder element circuit connected to an address buffer. The predecoder element circuit has a NAND gate 41. An output portion of the NAND gate 41 is connected to an inverter 42. Output addresses AN-1, AN, and AN+1 of an address buffer element circuit and a chip enable signal CE are input to the NAND gate 41.

Next, the circuit operation of the non-volatile memory according to the third embodiment will be described. In this case, AB shown in Fig. 12 is an address buffer element circuit shown in Fig. 2. PD of the combination circuit 1 is a predecoder element circuit shown in Fig. 3. XDn is an X decoder element circuit shown in Fig. 1 (ii). In this case, as a necessary condition, a predecoder element circuit of any of the combination circuits 1 and 2 of the three combination circuits has the structure shown in Fig. 3.

In the circuit shown in Fig. 4, when the logic level of the signal CE is L (namely, in the chip standby state), regardless of the logic levels of the address signals AN-1, AN, and AN+1, the NAND 41 outputs a signal in the L level.

Thus, the level of the signal A is always L. In other words, since a signal in the L level is always input to one of input signals of the NAND gate 19 of the X decoder XD shown in Fig. 1 (iii), the level of the output signal of the NAND gate 19 of the X decoder becomes H and the voltage level of the node n2 becomes H. Thus, even if the levels of the input signals of the gates of the PMOS 22 and the NMOS 23 that drive each word line become L, the levels of all the word lines are fixed to H.

Thus, in this embodiment, the predecoder element circuit outputs a signal in the L level in the case that the level of the signal CE is L. Thus, in the chip standby state, the level of the output signal of the node n2 can be fixed to H. Consequently, regardless of the level of the output signal of the address buffer element circuit, in the chip standby state, the levels of all the word lines are always set to H. Thus, in the chip standby state, the levels of the node n2 (the drain of the NMOS 23) and the node n1 (the source of the NMOS 23) always become H, thereby preventing a leak current due to the short channel effect from taking place.

In addition, unlike with the structure of the second embodiment, since the NAND gate 41 and the CE signal are used, the access speed according to the third embodiment is higher than that according to the second embodiment due to the mutual inductance effect of transistors. Moreover, in the third embodiment, the number of transistors can be reduced.

[Fourth Embodiment]

Fig. 5 is a circuit diagram showing an X decoder element circuit for use with a non-volatile memory according to a fourth embodiment of the present invention.

The fourth embodiment is a modification of an X decoder element circuit. The X decoder element circuit according to the fourth embodiment has an NAND gate 51. Two inverters 52 and 53 are connected to an output portion of the NAND gate 51. Output signals A and B of a predecoder element circuit are input to the NAND gate 51. An output portion of the inverter 53 is connected to one of input terminals of a NOR gate 54. A signal -CE is input to the other input terminal of the NOR gate 54. An inverter 55 is connected to an output portion of the NOR gate 54. As with the structure shown in Fig. 1 (iii), a PMOS 22 and an NMOS 23 are connected in serial between a node n2 (an output portion of an inverter 55) and a source voltage node. A signal C is input to gates of the PMOS 22 and the NMOS 23. A connected portion (n1) of the PMOS 22 and the NMOS 23 is connected to a word line W. A plurality of memory cells are connected to the word line W.

The signals A, B, and C are output signals of the combination circuits 1, 2, and 3 shown in Fig. 12.

Next, the circuit operation of the non-volatile memory according to the fourth embodiment will be described. In this case, AB shown in Fig. 12 is an address buffer element circuit shown in Fig. 2. PD of the combination circuit 1 is a predecoder element circuit shown in Fig. 1 (ii). XDn is an X decoder element circuit shown in Fig. 5.

When the logic level of the $\overline{CE}$ signal of the circuit shown in Fig. 5 is H (namely, in the chip standby state), regardless of the logic levels of the signals A and B, the level of the output signal of the NOR gate 54 is L.

Thus, the voltage level of the node n2 becomes H. Consequently, even if the levels of the input signals of the gates of the PMOS 22 and the NMOS 23 that drive each word lines become H or L, the levels of all the word lines are fixed to H.

Thus, according to the fourth embodiment, the X decoder element circuit has the NOR gate 54 and the inverter 55 that causes the voltage level of the node n2 to become H in the case that the level of the signal $\overline{CE}$ is H. Thus, in the chip standby state, the levels of the nodes n2 (the drain of the NMOS 23) and the node n1 (the source of the NMOS 23) always become H, thereby preventing a leak current due to the short channel effect from taking place. According to the fourth embodiment, since the address buffer element circuit shown in Fig. 2 and the predecoder element circuit shown in Fig. 1 (ii) can be used, the number of transistors can be reduced.

[Fifth Embodiment]

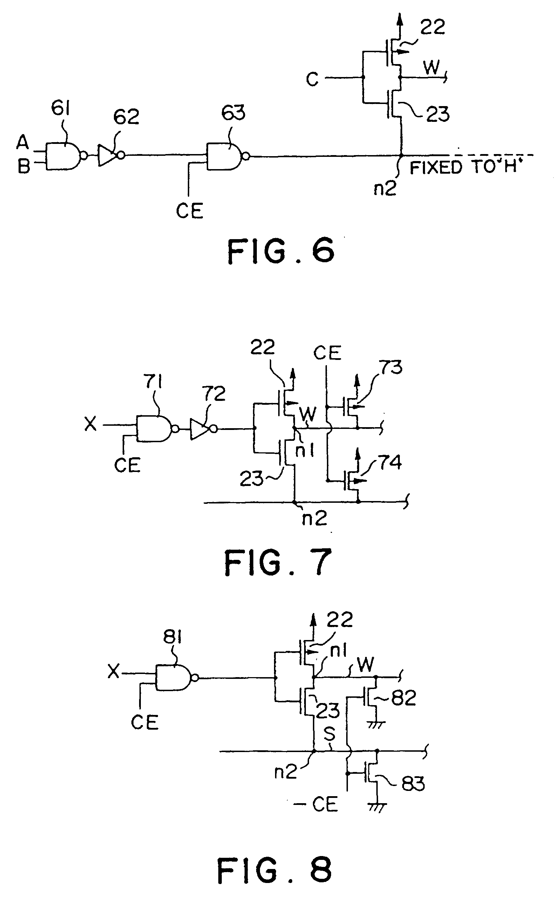

Fig. 6 is a block diagram showing an X decoder element circuit for use with a non-volatile memory according to a fifth embodiment of the present invention.

The fifth embodiment is a modification of an X decoder element circuit. The X decoder element circuit has an NAND gate 61. An inverter 62 is connected to an output portion of the NAND gate 61. Output signals A and B of a predecoder element circuit are input to the NAND gate 61. An output portion of the inverter 62 is connected to one of input terminals of the NAND gate 63. A CE signal is input to the other input terminal of the NAND gate 63. As with the structure shown in Fig. 1 (iii), a PMOS 22 and an NMOS 23 are connected in series between an output portion (node 2n2) of a NOR gate 63 and a source voltage node. A signal C is input to gates of the PMOS 22 and the NMOS 23. A connected portion (n1) of the PMOS 22 and the NMOS 23 is connected to a word line W. A plurality of memory cells are connected to the word line.

The signals A, B, and C are output signals of the combination circuits 1, 2, and 3 shown in Fig. 12.

Next, the circuit operation of the non-volatile memory according to the fifth embodiment will be described.

In this case, AB shown in Fig. 12 is an address buffer element circuit shown in Fig. 2. PD of the combination circuit 1 is a predecoder element circuit shown in Fig. 1 (ii). XDn is an X decoder element circuit shown in Fig. 6.

In the circuit shown in Fig. 6, when the logic level of the CE signal is L (namely, in the chip standby state), regardless of the logic levels of the signals A and B, the level of an output signal of the NAND gate 63 becomes H.

Thus, even if the levels of input signals of the gates of the PMOS 22 and the NMOS 23 that drive each word line become H or L, the levels of all the word lines are fixed to H.

According to the fifth embodiment, the X decoder element circuit has the NAND gate 63 that causes the voltage level of the node n2 to become H in the case that the level of the signal CE is L. Thus, in the chip standby state, the levels of the nodes n2 (a drain of the NMOS 23) and the node n1 (a source of the NMOS 23) always become H, thereby preventing a leak current due to the short channel effect from taking place. In the fifth embodiment, since the inverter 55 used in the structure of the fifth embodiment can be omitted, the access speed can be increased. In addition, the number of transistors can be reduced.

[Sixth Embodiment]

Fig. 7 is a circuit diagram showing an X decoder element circuit for use with a non-volatile memory according to a sixth embodiment of the present invention.

The sixth embodiment is a modification of the X decoder element circuit. The X decoder element circuit has an NAND gate 71. An inverter 72 is connected to an output portion of the NAND gate 71. An output signal X and a CE signal of a predecoder element circuit are input to the NAND gate 71. A PMOS 22 and an NMOS 23 are connected in series between a node n2 and a source voltage node. An output portion of the inverter 72 is input to gates of the PMOS 22 and the NMOS 23. A connected portion (n1) of the PMOS 22 and the NMOS 23 is connected to a word line W. A plurality of memory cells are connected to the word line.

In addition, PMOSs 73 and 74 are connected between the source voltage node and the node n1 and between the source voltage node and the node n2, respectively. A CE signal is input to gates of the PMOSs 73 and 74.

Next, the circuit operation of the non-volatile memory according to the sixth embodiment will be described.

In the circuit shown in Fig. 6, when the logic level of the CE signal is L (namely, in the chip standby state), regardless of the logic level of the signal X, the level of an output signal of the NAND gate 71 becomes H. Thus, the level of an output signal of the inverter 72 becomes L and the level of the word line W becomes H. At this point, since the level of the CE signal is L, the PMOSs 73 and 74 are turned on and the levels of the word line W and the node n2 are fixed to H.

Thus, according to the sixth embodiment, the X decoder element circuit has the PMOSs 73 and 74 that cause the voltage levels of the nodes n1 and n2 to become H in the case that the level of the signal CE is L. Thus, in the chip standby state, the levels of the node n2 and n1 always become H, thereby preventing a leak current due to the short channel effect from taking place. In addition, since the levels of input signals of gates of the PMOSs 73 and 74 are the same as the level of the signal CE and thereby the logic level of the node n2 is fixed to H, the access speed to the memory cells by the chip enable operation according to the sixth embodiment is higher than that of the first embodiment.

[Seventh Embodiment]

Fig. 8 is a circuit diagram showing an X decoder element circuit for use with a non-volatile memory according to a seventh embodiment of the present invention.

The seventh embodiment is a modification of an X decoder element circuit. The X decoder element circuit has an NAND gate 81 that inputs an output signal X of a predecoder element circuit and a CE signal. A PMOS 22 and an NMOS 23 are connected in series between a node n2 and a source voltage node. An output portion of the NAND gate 81 is connected to gates of the PMOS 22 and the NMOS 23. A connected portion (n1) of the PMOS 22 and the NMOS 23 is connected to a word line W. A plurality of memory cells are connected to the word line.

NMOSs 82 and 83 are connected between a ground voltage node and the node n1 and between the ground voltage node and the node n2, respectively. A -CE signal is input to gates of the NMOSs 82 and 83.

Next, the circuit operation of the non-volatile memory according to the seventh embodiment will be described.

When the logic level of the CE signal in the circuit shown in Fig. 8 is L (namely, in the chip standby state), regardless of the logic level of a signal X, the level of an output signal of the NAND gate 81 is H. Thus, the NMOS 23 is turned on and thereby the word line W is connected to the node n2. At this point, since the level of the -CE signal is H, the NMOSs 82 and 83 are turned on and thereby the levels of the word line W and the node n2 are fixed to L.

According to the seventh embodiment, the X decoder element circuit has the NMOSs 82 and 83 with sources that are connected to the ground voltage and that cause the voltage levels of the nodes n1 and n2 to become L in the case that the level of the signal CE is L. Thus, in the chip standby state, the levels of the nodes n2 and n2 always become L, thereby preventing a leak current due to the short channel effect from taking place. In addition, since the levels of input signals of gates of the NMOSs 82 and 83 are the same as the level of the signal CE and the logic level of the node n2 is fixed to H, the access speed to the memory cells by the chip enable operation according to the seventh embodiment is higher than that according to the first embodiment.

In addition, since the NAND gate 81 is used, the inverter 72 used in the structure of the seventh embodiment can be omitted. Thus, the access speed can be increased. Moreover, the number of transistors can be reduced.

[Eighth Embodiment]

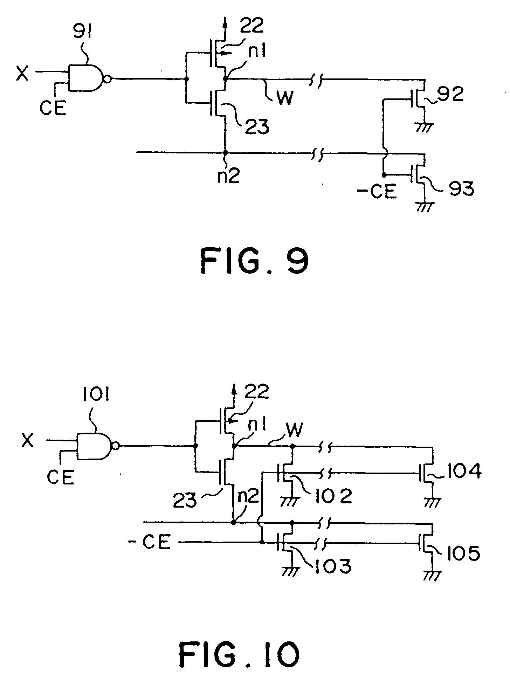

Fig. 9 is a circuit diagram showing an X decoder element circuit for use with an non-volatile memory according to an eighth embodiment of the present invention.

The eighth embodiment is a modification of an X decoder element circuit. Since the structure of the X decoder element circuit according to the eighth embodiment is similar to that of the structure shown in Fig. 8, only the different portions will be described in detail. In Fig. 8, the transistors that forcedly set the logic levels of the word line and the node n2 are disposed at an edge portion on the node n2 side of the word line. However, in the circuit shown in Fig. 9, transistors 92 and 93 that forcedly set the logic levels of the word line and the node n2 are disposed at an edge portion on the opposite side of the node n2 of the word line.

Although the X decoder shown in Fig. 9 operates in the same manner as the circuit shown in Fig. 8, since the NMOSs 92 and 93 are disposed at the edge portion opposite side of the node n2 of the word line, when the chip enable signal CE is input from the opposite side of the node n2, the access speed is increased.

[Ninth Embodiment]

Fig. 10 is a circuit diagram showing an X decoder element circuit for use with a non-volatile memory according to a ninth embodiment of the present invention.

The ninth embodiment is a modification of an X decoder element circuit. Since the structure of the X decoder element circuit according to the ninth embodiment is similar to the structure shown in Fig. 8 or 9, only the different portions will be described in detail. In Figs. 8 and 9, transistors that forcedly set the logic levels of the word line and the node n2 are disposed on one edge side of the word line. However, in the circuit shown in Fig. 10, transistors <102 and 103> and <104 and 105> that forcedly set the logic levels of the word line and the node n2 are disposed on both edge sides of the word line. Thus, regardless of the length of the word line, the voltage levels of the word line and the node n2 can be quickly set to L. Consequently, the access speed against the chip enable signal CE can be increased.

In the present invention, various modifications may be made, not limited to the above-described embodiments themselves. As a necessary condition of the present invention, the logic levels of both edge sides (node n1 and node n2) of an NMOS connected to a word line are set to the same levels in the chip standby state. Thus, the structures of the address buffer, the predecoder, and the X decoder can be modified corresponding to the application of the present invention.

In the above-described embodiments, the present invention was described as a non-volatile memory. However, the present invention can be applied to other semiconductor storing apparatuses.

Industrial Utilization

According to the present invention, since the logic levels on both edge sides (node n1 and node n2) of an NMOS connected to a word line are set to the same level corresponding to the logic level of the chip enable signal, even in a memory having an MOS transistor with a short gate length due to an increase of the storage capacity, a leak voltage can be prevented from taking place in the chip standby state.

**Claims**

1. A semiconductor memory device comprising a first conductive-type first transistor (22) connected between a predetermined voltage node and first node (n1), a second conductive-type second transistor (23) connected between the first node (n1) and a second node (n2), and a word line (W) connected to the first node (n1) and electrically connected to a memory cell where said second conductive type is different from said first conductive type, the semiconductor memory device being at a standby state when a control signal (CE) having a first voltage level is supplied, the gates of the first (22) and second (23) transistors being connected,

   the semiconductor memory device further comprising a control circuit controlling the voltage level of the second node (n2) in response to the control signal (CE) and an address information, the control circuit setting if the control signal (CE) has a second voltage level the voltage level of the second node (n2) dependent on said address information to the first voltage level or the second voltage level which is different from said first voltage level, **characterized in that** the control circuit setting the voltage level of the second node (n2) to substantially the same voltage level as that of the first node (n1) irrespective of the address information if the control signal has said first voltage level.

2. A semiconductor memory device as claimed in claim 1, **characterized in that** the control circuit comprises:

   a first logic circuit (17, 18, 19, 20, 21) with a plurality of input portions and an output portion connected to the second node (n2), said first logic circuit (17, 18, 19, 20, 21) being adapted for supplying the second voltage level to the second node (n2) in the case that at least one of the signals supplied to the plurality of input portions has a first voltage level; and
   a second logic circuit (11, 12, 13, 14, 15, 16) with input portions and two output portions, one of the output portions being connected to one of the input portions of said first logic circuit (17, 18, 19, 20, 21), said second logic circuit (11, 12, 13, 14, 15, 16) being adapted for outputting, in response to the chip enable signal inputted to one of the input portions, output signals of a first voltage level from the two output portions in the case that the chip enable signal has the first voltage level and outputting signals having complementary voltage levels from the two output portions if the chip enable signal has the second voltage level.

3. A semiconductor memory device as claimed in claim 1, **characterized in that** the control circuit comprises:

   a logic circuit (31, 32, 33, 41, 42) having a plurality of input portions for inputting a plurality of address signals or inverted signals thereof and the chip enable signal, said logic circuit (31, 32, 33, 41, 42) being adapted for supplying to the second node (n2) a signal having a voltage level corresponding to the voltage level of each of the address signals or each of the inverted address signals in the case that the chip enable signal has the second voltage level.

4. A semiconductor memory device as claimed in claim 3, wherein the logic circuit (31, 32, 33, 41, 42) is adapted for inputting an inverted chip enable signal instead of the chip enable signal (CE) and for supplying to the second node (n2) a signal having a voltage level corresponding to the voltage level of each of the address signals or the inverted address signals in the case that the inverted chip enable signal has the first voltage level.

5. A semiconductor memory device as claimed in claim 1, **characterized in that** the control circuit comprises:

   a logic circuit (61, 62, 63) having a plurality of input portions for inputting a reply signal corresponding to a plurality of address signals or inverted address signals and for inputting the chip enable signal (CE), and an output portion connected to the second node (n2), said logic circuit (61, 62, 63) being adapted for supplying a signal having the second voltage level to the second node (n2) irrespective of the voltage level of the reply signal in the case that the voltage level of the chip enable signal (CE) is the first voltage level, and for supplying to the second node (n2) a signal having a voltage level corresponding to the voltage level of the reply signal in the case that the chip enable signal has the second voltage level.

6. A semiconductor memory device as claimed in claim 5, **characterized in that** an inverted chip enable signal is inputted to the logic circuit (51, 52, 53, 54, 55) instead of the chip enable signal and that the logic circuit (51, 52, 53, 54, 55) is adapted for supplying to the second node (n2) a signal having a voltage level corresponding to the voltage level of the reply signal in the case that the inverted chip enable signal has the first voltage level.

**7.** A semiconductor memory device as claimed in claim 1, **characterized in that** the control circuit comprises:

a first conductive-type third transistor (73) connected between a constant voltage node and the first node (n1) and having a gate electrode for inputting the chip enable signal, and a first conductive-type fourth transistor (74) connected between the constant voltage node and the second node (n2) and having a gate electrode for inputting the chip enable signal (CE).

**8.** A semiconductor memory device as claimed in claim 1, **characterized in that** the control circuit comprises:

a second conductive-type third transistor (82) connected between the first node (n1) and the ground voltage node and having a gate electrode for inputting an inverted chip enable signal, and a second conductive-type fourth transistor (83) connected between the second node (n2) and the ground voltage node and having a gate electrode for inputting an inverted chip enable signal.

**Patentansprüche**

**1.** Halbleiterspeichervorrichtung, die einen ersten Transistor (22) eines ersten Leitungstyps, der zwischen einen vorgegebenen Spannungsknoten und einen ersten Knoten (n1) geschaltet ist, einen zweiten Transistor (23) eines zweiten Leitungstyps, der zwischen den ersten Knoten (n1) und einen zweiten Knoten (n2) geschaltet ist, und eine Wortleitung (W), die an den ersten Knoten (n1) angeschlossen und mit einer Speicherzelle elektrisch verbunden ist, umfaßt, wobei der zweite Leitungstyp vom ersten Leitungstyp verschieden ist und wobei sich die Halbleiterspeichervorrichtung in einem Bereitschaftszustand befindet, wenn ein Steuersignal (CE) mit einem ersten Spannungspegel geliefert wird, wobei die Gates der ersten (22) und zweiten (23) Transistoren verbunden sind,
wobei die Halbleiterspeichervorrichtung ferner eine Steuerschaltung umfaßt, die den Spannungspegel des zweiten Knotens (n2) als Antwort auf das Steuersignal (CE) und auf Adresseninformationen steuert, wobei die Steuerschaltung dann, wenn das Steuersignal (CE) einen zweiten Spannungspegel besitzt, den Spannungspegel des zweiten Knotens (n2) in Abhängigkeit von den Adresseninformationen auf den ersten Spannungspegel oder den zweiten Spannungspegel, der vom ersten Spannungspegel verschieden ist, setzt, **dadurch gekennzeichnet, daß** die Steuerschaltung den Spannungspegel des zweiten Knotens (n2) unabhängig von den Adresseninformationen im wesentlichen auf denselben Spannungspegel wie jenes des ersten Knotens (n1) setzt, wenn das Steuersignal den ersten Spannungspegel besitzt.

**2.** Halbleiterspeichervorrichtung nach Anspruch 1, **dadurch gekennzeichnet, daß** die Steuerschaltung umfaßt:

eine erste Logikschaltung (17, 18, 19, 20, 21) mit mehreren Eingangsabschnitten und einem Ausgangsabschnitt, der an den zweiten Knoten (n2) angeschlossen ist, wobei die erste Logikschaltung (17, 18, 19, 20, 21) so beschaffen ist, daß sie den zweiten Spannungspegel an den zweiten Knoten (n2) liefert, falls wenigstens eines der Signale, die an die mehreren Eingangsabschnitte geliefert werden, einen ersten Spannungspegel besitzt; und
eine zweite Logikschaltung (11, 12, 13, 14, 15, 16) mit Eingangsabschnitten und zwei Ausgangsabschnitten, wobei einer der Ausgangsabschnitte an einen der Eingangsabschnitte der ersten Logikschaltung (17, 18, 19, 20, 21) angeschlossen ist, wobei die zweite Logikschaltung (11, 12, 13, 14, 15, 16) so beschaffen ist, daß sie als Antwort auf das in einen der Eingangsabschnitte eingegebene Chipfreigabesignal Ausgangssignale mit einem ersten Spannungspegel von den beiden Ausgangsabschnitten ausgibt, falls das Chipfreigabesignal den ersten Spannungspegel besitzt, und Signale, die komplementäre Spannungspegel besitzen, von den beiden Ausgangsabschnitten ausgibt, falls das Chipfreigabesignal den zweiten Spannungspegel besitzt.

**3.** Halbleiterspeichervorrichtung nach Anspruch 1, **dadurch gekennzeichnet, daß** die Steuerschaltung umfaßt:

eine Logikschaltung (31, 32, 33, 41, 42) mit mehreren Eingangsabschnitten zum Eingeben mehrerer Adressensignale oder invertierter Signale hiervon und des Chipfreigabesignals, wobei die Logikschaltung (31, 32, 33, 41, 42) so beschaffen ist, daß sie an den zweiten Knoten (n2) ein Signal liefert, das einen dem Spannungspegel jedes der Adressensignale oder jedes der invertierten Adressensignale entsprechenden Spannungspegel besitzt, falls das Chipfreigabesignal den zweiten Spannungspegel besitzt.

**4.** Halbleiterspeichervorrichtung nach Anspruch 3, wobei die Logikschaltung (31, 32, 33, 41, 42) so beschaffen ist, daß sie statt des Chipfreigabesignals (CE) ein invertiertes Chipfreigabesignal eingibt und an den zweiten Knoten (n2) ein Signal liefert, das einen dem Spannungspegel jedes der Adressensignale oder der invertieren Adressensignale entsprechenden Spannungspegel besitzt, falls das invertierte Chipfreigabesignal den ersten Spannungspegel besitzt.

**5.** Halbleiterspeichervorrichtung nach Anspruch 1, **dadurch gekennzeichnet, daß** die Steuerschaltung umfaßt:

eine Logikschaltung (61, 62, 63) mit mehreren Eingangsabschnitten zum Eingeben eines Antwortsignals, das mehreren Adressensignalen oder invertierten Adressensignalen entspricht, und zum Eingeben des Chipfreigabesignals (CE) und einem Ausgangsabschnitt, der an den zweiten Knoten (n2) angeschlossen ist, wobei die Logikschaltung (61, 62, 63) so beschaffen ist, daß sie unabhängig vom Spannungspegel des Antwortsignals ein Signal, das den zweiten Spannungspegel besitzt, an den zweiten Knoten (n2) liefert, falls der Spannungspegel des Chipfreigabesignals (CE) der erste Spannungspegel ist, und an den zweiten Knoten (n2) ein Signal liefert, das einen dem Spannungspegel des Antwortsignals entsprechenden Spannungspegel besitzt, falls das Chipfreigabesignal den zweiten Spannungspegel besitzt.

**6.** Halbleiterspeichervorrichtung nach Anspruch 5, **dadurch gekennzeichnet, daß** in die Logikschaltung (51, 52, 53, 54, 55) anstatt des Chipfreigabesignals ein invertiertes Chipfreigabesignal eingegeben wird und daß die Logikschaltung (51, 52, 53, 54, 55) so beschaffen ist, daß sie an den zweiten Knoten (n2) ein Signal liefert, das einen Spannungspegel besitzt, der dem Spannungspegel des Antwortsignals entspricht, falls das invertierte Chipfreigabesignal den ersten Spannungspegel besitzt.

**7.** Halbleiterspeichervorrichtung nach Anspruch 1, **dadurch gekennzeichnet, daß** die Steuerschaltung umfaßt:

einen dritten Transistor (73) des ersten Leitungstyps, der zwischen einen Konstantspannungsknoten und den ersten Knoten (n1) geschaltet ist und eine Gate-Elektrode für die Eingabe des Chipfreigabesignals besitzt, und einen vierten Transistor (74) des ersten Leitungstyps, der zwischen den Konstantspannungsknoten und den zweiten Knoten (n2) geschaltet ist und eine Gate-Elektrode für die Eingabe des Chipfreigabesignals (CE) besitzt.

**8.** Halbleiterspeichervorrichtung nach Anspruch 1, **dadurch gekennzeichnet, daß** die Steuerschaltung umfaßt:

einen dritten Transistor (82) des zweiten Leitungstyps, der zwischen den ersten Knoten (n1) und den Massespannungsknoten geschaltet ist und eine Gate-Elektrode für die Eingabe eines invertierten Chipfreigabesignals besitzt, und einen vierten Transistor (83) des zweiten Leitungstyps, der zwischen den zweiten Knoten (n2) und den Massespannungsknoten geschaltet ist und eine Gate-Elektrode für die Eingabe eines invertierten Chipfreigabesignals besitzt.

## Revendications

**1.** Dispositif de mémoire à semi-conducteurs comprenant un premier transistor (22) du premier type conducteur connecté entre un noeud à une tension prédéterminée et un premier noeud (n1), un deuxième transistor (23) du deuxième type conducteur connecté entre le premier noeud (n1) et un deuxième noeud (n2), et une ligne de coordination (W) connectée au premier noeud (n1) et connectée électriquement à un élément de mémoire, ledit deuxième type conducteur étant différent dudit premier type conducteur, le dispositif de mémoire à semi-conducteurs étant à l'état d'attente lorsqu'un signal de commande (CE) ayant un premier niveau de tension est fourni, les portes du premier transistor (22) et du deuxième transistor (23) étant connectées,

le dispositif de mémoire à semi-conducteurs comprenant, en outre, un circuit de commande commandant le niveau de tension du deuxième noeud (n2) en réponse au signal de commande (CE) et à une information d'adresse, le circuit de commande fixant, si le signal de commande (CE) a un deuxième niveau de tension, le niveau de tension du deuxième noeud (n2) en fonction de ladite information d'adresse, au premier niveau de tension, ou au deuxième niveau de tension, qui est différent dudit premier niveau de tension, **caractérisé en ce que** le circuit de commande fixe le niveau de tension du deuxième noeud (n2) sensiblement au même niveau de tension que celui du premier noeud (n1) quelle que soit l'information d'adresse, si le signal de commande est audit premier niveau de tension.

**2.** Dispositif de mémoire à semi-conducteurs selon la revendication 1, **caractérisé en ce que** le circuit de commande comprend :

un premier circuit logique (17, 18, 19, 20, 21) comportant une pluralité de parties d'entrée et une partie de sortie connectée au deuxième noeud (n2), ledit premier circuit logique (17, 18, 19, 20, 21) étant apte à fournir le deuxième niveau de tension au deuxième noeud (n2) dans le cas où au moins un des signaux fournis à la pluralité de parties d'entrée a un premier niveau de tension ; et

un deuxième circuit logique (11, 12, 13, 14, 15, 16) comportant des parties d'entrée et deux parties de sortie, une des parties de sortie étant connectée à une des parties d'entrée dudit premier circuit logique (17, 18, 19, 20, 21), ledit deuxième circuit logique (11, 12, 13, 14, 15, 16) étant apte à émettre, en réponse au signal de validation de puce introduit dans l'une des parties d'entrée, des signaux de sortie ayant un premier niveau de tension provenant des deux parties de sortie dans le cas où le signal de validation de puce a le premier niveau de tension et les signaux de sortie ayant des niveaux de tension complémentaires provenant des deux parties de sortie si le signal de validation de puce a le deuxième niveau de tension.

3. Dispositif de mémoire à semi-conducteurs selon la revendication 1, **caractérisé en ce que** le circuit de commande comprend :

   un circuit logique (31, 32, 33, 41, 42) comportant une pluralité de parties d'entrée destinées à l'introduction d'une pluralité de signaux d'adresse ou de signaux inversés de ceux-ci et du signal de validation de puce, ledit circuit logique (31, 32, 33, 41, 42) étant apte à fournir au deuxième noeud (n2) un signal ayant un niveau de tension qui correspond au niveau de tension de chacun des signaux d'adresse ou de chacun des signaux d'adresse inversés dans le cas où le signal de validation de puce a le deuxième niveau de tension.

4. Dispositif de mémoire à semi-conducteurs selon la revendication 3, dans lequel le circuit logique (31, 32, 33, 41, 42) est apte à introduire un signal de validation de puce inversé au lieu du signal de validation de puce (CE) et à fournir au deuxième noeud (n2) un signal ayant un niveau de tension qui correspond au niveau de tension de chacun des signaux d'adresse ou des signaux d'adresse inversés dans le cas où le signal de validation de puce inversé a le premier niveau de tension.

5. Dispositif de mémoire à semi-conducteurs selon la revendication 1, **caractérisé en ce que** le circuit de commande comprend :

   un circuit logique (61, 62, 63) comportant une pluralité de parties d'entrée destinées à l'introduction d'un signal de réponse correspondant à une pluralité de signaux d'adresse ou de signaux d'adresse inversés et à l'introduction du signal de validation de puce (CE), et une partie de sortie connectée au deuxième noeud (n2), ledit circuit logique (61, 62, 63) étant apte à fournir un signal ayant le deuxième niveau de tension au deuxième noeud (n2), quel que soit le niveau de tension du signal de réponse dans le cas où le niveau de tension du signal de validation de puce (CE) est le premier niveau de tension, et à fournir au deuxième noeud (n2) un signal ayant un niveau de tension qui correspond au niveau de tension du signal de réponse dans le cas où le signal de validation de puce a le deuxième niveau de tension.

6. Dispositif de mémoire à semi-conducteurs selon la revendication 5, **caractérisé en ce qu'**un signal de validation de puce inversé est introduit dans le circuit logique (51, 52, 53, 54, 55) au lieu du signal de validation de puce et **en ce que** le circuit logique (51, 52, 53, 54, 55) est apte à fournir au deuxième noeud (n2) un signal ayant un niveau de tension qui correspond au niveau de tension du signal de réponse dans le cas où le signal de validation de puce inversé a le premier niveau de tension.

7. Dispositif de mémoire à semi-conducteurs selon la revendication 1, **caractérisé en ce que** le circuit de commande comprend :

   un troisième transistor (73) du premier type conducteur connecté entre un noeud à tension constante et le premier noeud (n1) et ayant une électrode de porte destinée à l'introduction du signal de validation de puce et un quatrième transistor (74) du premier type conducteur connecté entre le noeud à tension constante et le deuxième noeud (n2) et ayant une électrode de porte destinée à l'introduction du signal de validation de puce (CE).

8. Dispositif de mémoire à semi-conducteurs selon la revendication 1, **caractérisé en ce que** le circuit de commande comprend :

   un troisième transistor (82) du deuxième type conducteur, connecté entre le premier noeud (n1) et le noeud à la tension de masse et ayant une électrode de porte destinée à l'introduction d'un signal de validation de puce inversé, et un quatrième transistor (83) du deuxième type conducteur, connecté entre le deuxième noeud (n2) et le noeud à la tension de masse et ayant une électrode de porte destinée à l'introduction d'un signal inversé de validation de puce.

FIG. 1 (i)

FIG. 1 (ii)

FIG. 1 (iii)

FIG. 2

FIG. 3

FIG. 4

FIG. 5

FIG. 6

FIG. 7

FIG. 8

FIG. 9

FIG. 10

FIG. 11

FIG. 12